# FASCICULE DE BREVET EUROPEEN

(11) **EP 0 896 370 B1**
(45) Date de publication et mention de la délivrance du brevet: **11.04.2012**
(21) Numéro de dépôt: 98402008.1
(22) Date de dépôt: 06.08.1998
(51) Int. Cl.: H01L 29/788, H01L 21/336, H01L 27/115, H01L 21/8247, H01L 27/12, H01L 21/84, G11C 16/04

(54) **Dispositif de mémoire à grille flottante sur SOI et procédé de fabrication correspondant**
Schwebegatterspeicherelement auf SOI und entsprechendes Herstellungsverfahren
Floating-gate memory device on SOI and corresponding manufacturing process

(30) Priorité: 08.08.1997 FR 9710223
(43) Date de publication de la demande: 10.02.1999
(73) Titulaire: Commissariat à l'Énergie Atomique et aux Énergies Alternatives, 75015 Paris (FR)
(72) Inventeur: Hartmann, Joel, 38640 Claix (FR); Belleville, Marc, 38120 Saint Egrève (FR)
(74) Mandataire: Moutard, Pascal Jean

(56) Documents cités:
- EP-A- 0 682 370
- EP-A- 0 712 163
- EP-A1- 0 776 049
- US-A- 5 501 996

## Description

### Domaine technique et art antérieur

La présente invention concerne la description d'un dispositif mémoire non volatile, programmable et effaçable électriquement (EEPROM) et sélectivement bit par bit. L'utilisation d'une technologie CMOS/SOI standard, donc sans étape technologique spécifique permet d'envisager l'intégration de ce type de points mémoire EEPROM dans des circuits logiques CMOS sans modification de la technologie de fabrication.

Les mémoires non volatiles EEPROM programmables et effaçables électriquement existent depuis le milieu des années 1970 (cellule de type FLOTOX inventée par INTEL). Elles se caractérisent par un procédé de fabrication à deux niveaux de silicium polycristallin (grille flottante et grille de contrôle), des tensions de programmation et d'effacement généralement élevées (>15V) et un point mémoire complexe avec un transistor d'accès, un transistor à double grille et une zone d'effacement avec une épaisseur d'oxyde de grille très réduite (oxyde tunnel).

Pour des raisons de complexité technologique et de surface importante du point mémoire, ce type de produit a peu évolué en volume de production et en densité d'intégration. Les densités maximales ont été de l'ordre de 256 Kbits. Dans le même temps, les mémoires EPROM, puis récemment les mémoires Flash EPROM ont connu un fort développement économique ainsi qu'une évolution rapide vers les grandes densités d'intégration (>l6Mbits aujourd'hui). Cependant, le besoin d'intégrer des fonctionnalités de mémoire non volatile sur des circuits logiques s'est rapidement fait sentir dans le milieu des années 1980, notamment avec l'introduction des premiers microcontrôleurs. Pour reprogrammer rapidement ces points mémoires, il a été nécessaire de pouvoir les effacer électriquement, ce qui a donc rendu, pour cette application, la mémoire EEPROM plus attrayante que la mémoire EPROM. D'un point de vue du fonctionnement entre la zone mémoire et le circuit logique, il s'est avéré utile de pouvoir effacer ces points mémoire de manière sélective, indépendamment les uns des autres, d'où l'intérêt d'un point mémoire EEPROM plutôt que Flash EPROM. Enfin, pour des raisons de coûts de fabrication et de compatibilité de procédés, il est très avantageux d'avoir un procédé CMOS permettant à la fois de réaliser le plan mémoire EEPROM et la partie logique avec un minium de modifications de la technologie. D'où l'intérêt des points mémoires EEPROM simple poly, c'est-à-dire ayant un seul niveau de silicium polycristallin. De nombreux points mémoires de ce type ont été publiés dans les revues et les conférences scientifiques du domaine.

L'article de J.I. Miyamoto et al. Intitulé "experimental 5V only 256 kbits CMOS EEPROM with a high performance single polysilicon cell" paru dans IEEE Journal of Solid-State circuits, vol. SC-21, N° 5, 1986, p.852-859 décrit un point mémoire à un seul niveau de silicium polycristallin qui utilise une zone de diffusion N+ comme grille de contrôle, et le niveau unique de silicium polycristallin pour la grille des MOS de la partie logique et pour la grille flottante du plan mémoire EEPROM.

Malgré une fonctionnalité intéressante et, déjà, une utilisation courante de ce type de point mémoire dans la réalisation de circuits intégrés, ce type de point mémoire est limité en densité d'intégration compte tenu de sa surface importante (taille de la cellule de l'ordre de 100 µm² pour une technologie 1,2 µm et 70 µm² pour une technologie 0,7 µm). De plus, comme dans les mémoires EEPROM à double poly, ce type de structure présente un problème de fiabilité d'oxyde tunnel lié à la surface importante de la zone d'oxyde tunnel. Ce type de point mémoire nécessite, enfin, des tensions de programmation importantes ainsi qu'une isolation particulière de la zone N⁺ définissant la grille de contrôle.

L'article de K. Ohsaki et al. Intitulé "A single poly EEPROM cell structure for use in standard CMOS process" paru dans IEEE Journal of Solid-State circuits, vol. 29, n° 3, up. 311-316 (1994) décrit un autre type de point mémoire EEPROM utilisant lui aussi un seul niveau de silicium polycristallin. Sa particularité est d'utiliser un procédé CMOS sur silicium massif conventionnel (sans étapes technologiques spécifiques) : le point mémoire est constitué d'un transistor NMOS et d'un transistor PMOS adjacents dont les grilles sont communes. Ces grilles sont en fait des grilles flottantes. La couche d'inversion sous le transistor PMOS ainsi que la diffusion S/D P+ jouent le rôle de grille de contrôle. Les zones de source et de drain du transistor NMOS sont reliées à la masse. La taille de la cellule est ici plus compacte (31 µm² pour des règles de dessin de 0,8 µm), mais elle souffre encore d'une distance minimum importante à respecter entre le transistor NMOS

Ce dispositif comporte une isolation latérale directe du point mémoire par les zones d'isolement. Il ne nécessite donc pas de tranchées d'isolement.

De plus, la structure selon l'invention ne nécessite qu'un film semi-conducteur d'épaisseur faible, de l'ordre de quelques dixièmes de µm (de 0,1 à 0,3 µm, par exemple), qui se compare très avantageusement à l'épaisseur de 1 à 2 µm nécessaire dans le dispositif décrit dans le document FR-2 726 935.

L'isolation diélectrique des composants, obtenue grâce aux zones d'isolement, est totale, et permet de réduire au minimum la distance d'isolement entre les transistors, dans un dispositif comportant plusieurs points mémoires.

Selon un premier mode de réalisation les zones d'isolement du point mémoire sont réalisées par un oxyde de champ.

Selon un autre mode de réalisation, les zones d'isolement du point mémoire sont réalisées par gravure localisée du film de semiconducteur jusqu'à la couche isolante.

Le dispositif de mémorisation selon l'invention met en oeuvre uniquement des transistors d'un seul type de conductivité dans le plan mémoire, que ce soient des transistors de stockage ou de sélection. Il en résulte une simplification des procédés de réalisation par rapport à un point mémoire NMOS et PMOS nécessitant une grille duale N⁺ et P⁺.

L'isolation diélectrique totale de la grille de contrôle réalisée en diffusion permet d'utiliser une tension de contrôle de signe indifférent (positive ou négative) ainsi que de fortes valeurs de tensions de contrôle sans risque de perçage ou de fuite électrique.

Un transistor de sélection peut être utilisé en liaison avec chaque point mémoire. En particulier, une grille de sélection du transistor de sélection, reliée à la zone de stockage de l'information permet de ne sélectionner, en écriture, lecture ou effacement que le point mémoire considéré.

Un transistor de sélection peut aussi être associé à une pluralité de pointe mémoire pour permettre la commande et/ou l'effacement de cette pluralité de points mémoire.

L'invention est également définie par le procédé de fabrication selon la revendication 9.

et le transistor PMOS pour éviter tout risque de "Latch-Up" (verrouillage du thyristor parasite). Enfin, le point mémoire considéré ne possède pas de transistor de sélection, comme dans l'article de Miyamoto et al. et oblige donc, soit à une écriture collective de points mémoires, soit à un effacement collectif.

La demande de brevet FR-2 726 935 décrit également un point mémoire réalisé dans une structure de type SOI (silicium sur isolant). Cependant, la technologie utilisée dans ce document correspond à une technologie silicium massif. En effet, pour isoler les points mémoires, des tranchées d'isolement sont nécessaires. Les documents US 5 501 996 et EP 0 776 049 décrivent des points mémoires à un seul niveau de silicium, par example du type SOI pour le document US 5 501 996.

### Exposé de l'invention

La présente invention a pour objet la réalisation d'un point mémoire non volatile de type EEPROM, programmable et effaçable électriquement bit par bit, et possédant la particularité de pouvoir être réalisé de manière conventionnelle dans un procédé CMOS/SOI.

De plus, la surface de point mémoire doit de préférence être faible.

Plus précisément, l'invention est définie par le dispositif selon l'une des revendications 1, 7 et 8.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- la figure 1 représente une vue schématique de dessus d'un dispositif selon l'invention comportant une pluralité de points mémoire,
- les figures 2A à 2C représentent des coupes schématiques d'un dispositif à mémoire conforme à l'invention, respectivement selon les plans AA', BB' et CC' de la figure 1,
- les figures 3 et 4 représentent d'autres modes de réalisation d'un dispositif selon l'invention comportant une pluralité de points mémoire.

### Description détaillée de modes de réalisation de l'invention

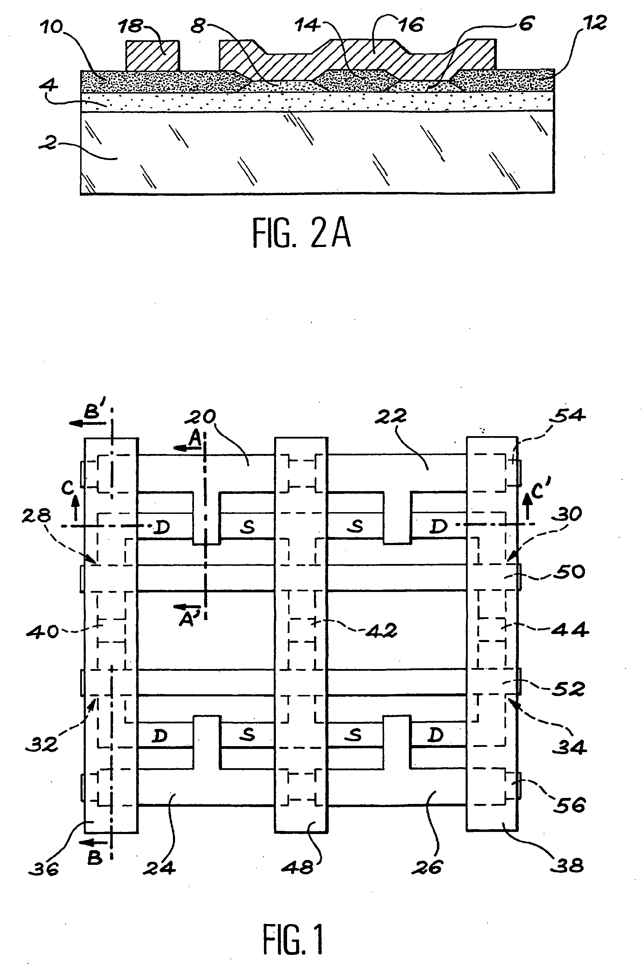

La figure 1 est une vue de dessus d'un exemple de réalisation d'un dispositif selon l'invention.

Une première coupe, selon AA', de ce dispositif, est illustrée en figure 2A. Cette figure représente un point mémoire d'un dispositif à mémoire non-volatile, réalisé sur un substrat 2, en silicium massif par exemple. Ce substrat est de type SIMOX (ou "Wafer Bonding") et est recouvert d'une couche 4 d'oxyde enterré (ayant une épaisseur d'environ 400 nm). L'ensemble est surmonté d'une couche active 6, 8 de semi-conducteur (par exemple en silicium), d'épaisseur égale à quelques 1/10è de µm, par exemple comprise entre 0,1 µm et 0,3 µm (par exemple : 0,2 µm).

Les références 6 et 8 désignent respectivement une zone grille de contrôle (à dopage P⁺ réalisé dans la couche active P de semi-conducteur) et une zone de canal de type P du transistor de stockage. Ces deux éléments sont séparés par une zone d'isolation 14. Par la suite, les zones d'isolement sont données réalisées par des oxydes de champ, à titre d'exemple. Les zones de grille de contrôle et de canal sont surmontées d'une grille flottante 16. De chaque côté, des zones 10, 12 d'oxyde de champ, en contact avec la couche 4 d'oxyde enterré, isolent le dispositif de son environnement.

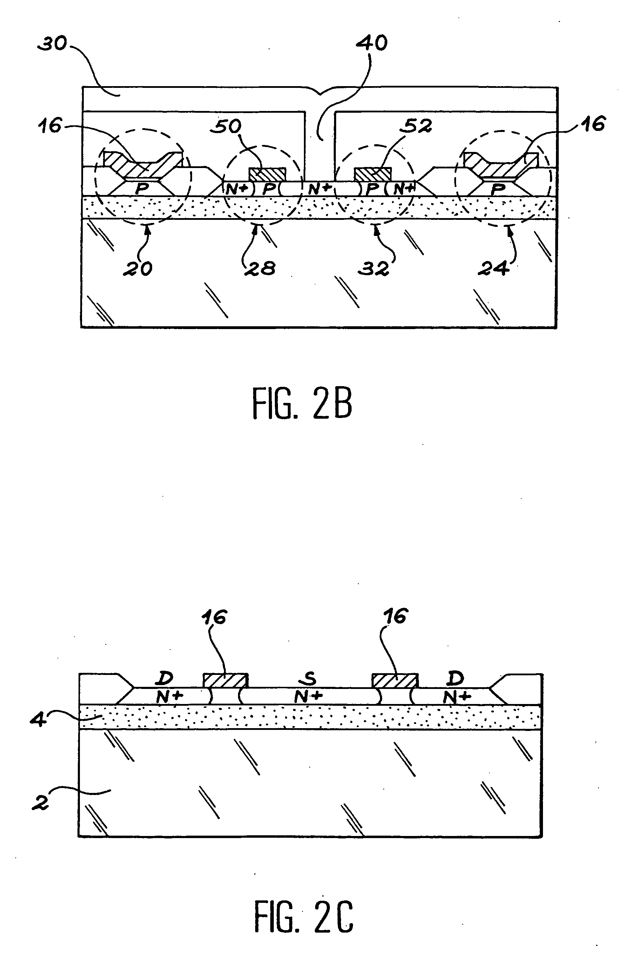

Des zones source S et drain D sont définies par dopage N⁺ de part et d'autre de la grille flottante 16, comme illustré sur les figures 1 et 2C.

La référence 18 désigne la grille d'un transistor de sélection associé au point mémoire représenté.

Ce transistor de sélection est représenté sur la figure 2B, qui correspond à la coupe selon le plan BB' de la figure 1;

les grilles de commande 16 des transistors de sélection 28, 32 sont confondues avec les lignes des mots 50 et 52.

De part et d'autre de la grille de commande dans le film semi-conducteur, ce transistor de sélection comporte une source et un drain qui sont réalisés avantageusement en même temps que ceux du transistor de stockage. La source (respectivement le drain) du transistor de sélection étant dans une zone active commune avec le drain (respectivement la source) du transistor de stockage.

De même la grille du contrôle et l'oxyde de grille du transistor de sélection sont réalisés avantageusement en même temps que l'oxyde de grille et la grille flottante du transistor de stockage.

Le dispositif selon l'invention comporte donc, dans un film semi-conducteur séparé par une couche isolante 4 du reste du substrat 2 (structure de type SOI) au moins un point mémoire isolé latéralement par des oxydes de champ 10, 12 en contact avec la couche isolante 4, ce point mémoire comprenant un transistor dont la grille de contrôle 6 est réalisée par une zone de diffusion dans le film, la grille flottante 16 étant formée au-dessus d'une zone de canal 8 réalisée dans le film semi-conducteur entre une zone de source S et une zone de drain D et au-dessus de la grille de contrôle.

Un exemple de procédé pour réaliser une telle structure va maintenant être décrit.

Ce procédé peut comprendre un ajustement préalable du dopage du film semiconducteur, qui est dans cet exemple de type P, par implantation ionique de bore, suivie d'un recuit au four. On réalise ensuite les zones d'isolement 12, 14 par un procédé de type LOCOS ("Localized Oxidation of silicon") conventionnel. L'oxyde de champ de cette isolation rejoint, après croissance thermique, l'oxyde enterré du substrat de type SOI, permettant ainsi une isolation diélectrique totale des composants MOS entre eux. Suivent ensuite des étapes d'oxydation sacrificielle, d'ajustement des dopages P de canal et P+ de grille de contrôle et d'oxydation de grille(s) du plan mémoire. On définit ensuite respectivement la, ou les, grille(s) du plan mémoire par dépôt de silicium polycristallin dopé au phosphore. Ces grilles sont définies par une étape de photolithographie puis de gravure plasma, sèche et anisotrope. Ensuite, les implantations N+ de source et de drain du plan mémoire sont effectuées et recuites. Cette étape peut être complétée par une implantation de type LDD. On procède enfin aux interconnexions par dépôt et fluage d'un verre dopé au bore et au phosphore pour assurer l'isolement entre les grilles et le niveau métal, puis photogravure des trous de contact, métallisation des contacts par dépôt d'une barrière Ti/TiN, remplissage de tungstène et dépôt d'un alliage d'aluminium Al-Cu avec 0,5% du Cu. Après photogravure du niveau métallique on procède enfin à un dépôt d'une couche de passivation constituée d'un verre dopé au phosphore puis à la photogravure des ouvertures des plots de soudure.

Le procédé de réalisation du plan mémoire s'intègre parfaitement dans un procédé de fabrication d'un circuit intégré de type CMOS. Autrement-dit les éléments du circuit intégré autres que lé plan mémoire sont réalisés en même temps que celui-ci. Par exemple la réalisation du dopage source et drain des transistors du circuit intégré est réalisé lors du dopage des sources et drains du plan mémoire.

La figure 1 représente un dispositif de mémorisation comportant 4 transistors de mémorisation 20, 22, 24, 26 conformes à l'invention et ayant la structure décrite ci-dessus. Chacun de ces points mémoires est associé à un transistor de sélection 28, 30, 32, 34.

Des lignes de bit 36, 38 relient, par des zones de contact 40, 44, les drains des points mémoires 20, 22, 24, ,26.

Une ligne de source 48 relie, par la zone de contact 42, les sources des points mémoire 20, 22, 24, 26.

Des lignes de mots 50, 52 commandent les transistors de sélection 28, 30, 32, 34 qui commandent eux-mêmes les grilles de contrôle des transistors de stockage.

Des lignes d'écriture et d'effacement 54, 56 permettent la programmation des points mémoire et/ou leur effacement collectif ou individuel :
- on programme un point, par porteurs chauds, en appliquant une tension de programmation sur une ligne d'écriture et d'effacement, en sélectionnant le transistor d'accès correspondant par la grille de contrôle et en appliquant une tension de drain sur la ligne de bit correspondante,
- on efface collectivement en appliquant une forte tension positive sur une ligne d'écriture et d'effacement (effacement par effet Fowler-Nordheim entre la grille et le canal des cellules communes à la même ligne d'écriture et d'effacement) ; il est également possible d'effacer une cellule individuellement, comme une EEPROM, en appliquant une légère tension négative sur sa ligne d'écriture et d'effacement, et en appliquant une tension positive sur sa ligne de bit (effacement par effet Fowler-Nordheim entre la grille et le drain).

Chaque point mémoire est donc formé d'un transistor de sélection et d'un transistor de stockage de charge dont la grille est flottante. Le transistor de sélection permet d'adresser le plan mémoire sélectivement bit par bit à l'aide d'une grille de contrôle et d'une ligne de bit. Ce transistor de sélection permet notamment d'éliminer tous les phénomènes parasites de perturbation des cellules voisines lors de la programmation et/ou de l'effacement d'une cellule donnée du plan mémoire. La structure de point mémoire selon l'invention permet de rapprocher considérablement le transistor d'accès du transistor de stockage, et donc de réduire de manière sensible la surface du point mémoire. La programmation et l'effacement sont contrôlés par une ligne de programmation, réalisée par une zone de diffusion dans le substrat de silicium. La connexion à la masse est assurée par une ligne de masse 48 contactée à chaque transistor de sélection. La technologie utilise avantageusement un substrat de silicium sur SOI permettant de polariser la ligne de programmation-effacement indifféremment en valeur positive ou en valeur négative, sans risque de conduction électrique parasite de jonctions sous-jacentes, comme cela serait fatalement le cas pour une technologie sur substrat massif. De plus, l'utilisation d'un substrat de type SOI permet de rapprocher les zones actives de types de conductions opposés à la distance minimum autorisée par la lithographie, sans risque de conduction parasite (phénomène dit de "latch-up") bien connu en technologie sur substrat massif.

Différents modes de fonctionnement (qui ne sont pas revendiqués) du point mémoire vont maintenant être considérés.

En lecture, pour accéder à un point mémoire, une tension positive nominale (5V pour du 0,7µm, 3,3V pour du 0,5 et du 0,35µm et 2,5V pour du 0,25µm) est appliquée sur la grille de contrôle correspondante. Une faible tension positive (de l'ordre de 1V) est appliquée sur la ligne de bit correspondante, et une tension de 0V (masse) est appliquée sur la ligne de masse correspondante. Dans ces conditions, le transistor d'accès à ce point mémoire est rendu conducteur et la tension de ligne de bit est transmise au transistor de stockage de l'information. Ce transistor a une grille flottante (non connectée à une électrode) recouvrant à la fois une zone de canal du côté, du transistor de sélection, et une zone de canal du côté de la grille d'écriture-effacement 6 ou 54. Une tension positive nominale est également appliquée à cette grille d'écriture-effacement. Si la grille flottante n'est pas chargée en électrons, le transistor de stockage va être rendu conducteur par cette tension nominale et un courant électrique va circuler entre la ligne de bit correspondante et la ligne de masse. On pourra lire un niveau logique 1. Si au contraire, la grille flottante a été préalablement chargée en électrons, un décalage de tension de seuil du transistor de stockage va apparaître, et la tension nominale sur la grille d'écriture-effacement ne sera pas suffisante pour rendre conducteur ce transistor. Aucun courant ne pourra alors circuler entre la ligne de bit et la ligne de masse. On pourra alors lire un niveau logique 0.

La programmation du transistor de stockage, ou l'injection d'électrons dans sa grille flottante, est réalisée de la manière suivante : pour accéder en lecture à un point mémoire, une tension positive nominale est à nouveau appliquée sur la grille de contrôle. Une forte tension positive (de l'ordre de quelques volts) est appliquée sur la ligne de bit correspondante, et une tension de 0v (masse) est appliquée sur la ligne de masse. Dans ces conditions, le transistor d'accès au point mémoire est rendu conducteur et la tension de ligne de bit est transmise au drain du transistor de stockage de l'information. Une tension positive élevée est alors appliquée à la ligne d'écriture-effacement correspondante, de manière à rendre conducteur le transistor de stockage en régime de saturation. Comme dans une mémoire EPROM, des porteurs chauds (énergétiques) sont alors injectés dans la grille flottante jusqu'à obtenir un décalage suffisant de la tension de seuil de ce transistor. Il est possible de réduire la valeur de la tension appliquée à la ligne d'écriture-effacement en augmentant la surface de la grille flottante en regard de cette ligne de programmation, par rapport à la surface de la grille flottante en regard de la zone active du côté du transistor de sélection. Cette augmentation de surface a pour effet d'augmenter le couplage capacitif entre la grille flottante et la ligne d'écriture-effacement, c'est-à-dire d'augmenter la valeur de la tension appliquée par couplage capacitif à la grille flottante pendant la phase de programmation.

Pour effacer un point mémoire, c'est-à-dire pour enlever les électrons préalablement stockés dans la grille flottante de ce point mémoire, on procède de la manière suivante : on applique toujours une tension positive nominale sur la grille de contrôle correspondante. Une tension positive importante (de l'ordre de quelques volts) est alors appliquée sur la ligne de bit correspondante, et une tension de 0V est appliquée sur la ligne de masse correspondante. Dans ces conditions, le transistor d'accès au point mémoire est rendu conducteur, et la tension de ligne de bit est transmise au transistor de stockage de l'information.

Une tension légèrement négative est alors appliquée à la ligne d'écriture-effacement 6 ou 54. Un champ électrique important apparaît alors entre la grille flottante et le drain du transistor de stockage et un courant électrique traversant l'oxyde de grille décharge la grille flottante de ses électrons. Ce mode d'effacement permet d'éliminer les électrons de grille flottante, sélectivement dans le point mémoire sélectionné. En effet, la faible valeur négative, appliquée sur la ligne d'écriture-effacement aux autres cellules voisines du point mémoire considéré, n'est pas suffisante pour décharger les éventuelles cellules voisines programmées.

A l'inverse, si l'on souhaite, en fonction de l'application visée, effacer collectivement un ensemble de points mémoires, ou même le plan mémoire tout entier, il est alors possible d'appliquer une tension positive importante sur une ligne d'écriture-effacement, ainsi qu'une tension nulle sur la ligne de bit. Les conditions de polarisation de la ligne de mot et de la ligne de masse restent inchangées. Les conditions de polarisation autour du transistor de stockage se trouvent alors inversées par rapport à la phase de programmation. Les électrons stockés dans la grille flottante sont évacués par conduction à travers l'oxyde de grille, du point mémoire vers l'électrode de programmation-effacement. Par la même occasion toutes les cellules, adjacentes à la cellule N et déjà programmées, sont effacées collectivement par conduction vers l'électrode de programmation-effacement.

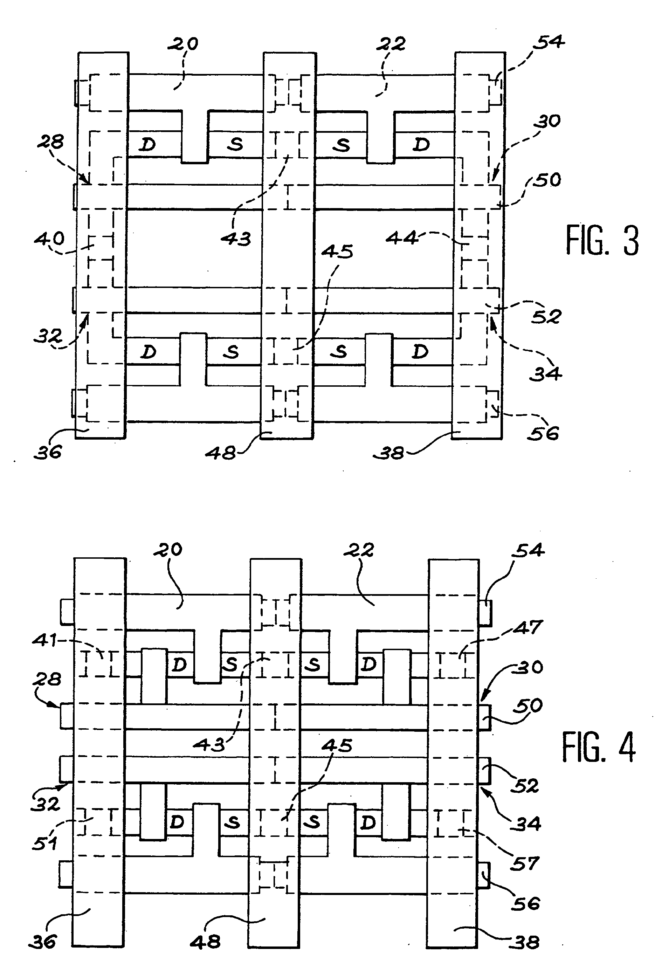

La figure 3 illustre un autre mode de réalisation de l'invention. Sur cette figure, des références numériques ou lettres identiques à celles de la figure 1 y désignent des éléments identiques ou correspondants. Les zones de contact source 43, 45 sont placées différemment par rapport au mode de réalisation de la figure 1. En fait, la source est commune à plusieurs points mémoires, et au même potentiel pour ces points.

La figure 4 représente une variante du mode de réalisation qui vient d'être décrit : le principe de fonctionnement est le même, mais la répartition des points de contact est différente. En particulier, les zones de contact 41, 51, 47, 57 des lignes de bit 36, 38 sur chacun des points mémoires correspondent aux zones de contact 40, 44 des figures 2 et 3.

## Revendications

1. Dispositif à mémoire non volatile, électriquement effaçable, comportant, dans un film semi-conducteur de type P séparé par une couche isolante (4) d'un substrat (2), un point mémoire du type à grille flottante (16), défini par une zone de source (S), une zone de drain (D), une zone de canal (8) et une zone de grille de contrôle (6), cette dernière étant séparée de la zone de canal (8) par une zone d'isolement (14), ces cinq zones étant réalisées dans ledit film semi-conducteur, ce point mémoire étant isolé latéralement par une, ou des, zone(s) d'isolement (10, 12), le dopage de la zone de canal (8) étant de type P, le dopage des zones de source (S) et de drain (D) étant de type N+, **caractérisé en ce que**
lesdites zones d'isolement (10, 12, 14) sont en contact avec ladite couche isolante (4) et le dopage de la zone de grille de contrôle (6) est de type P+.

2. Dispositif selon la revendication 1, ledit point mémoire étant un transistor dont la grille de contrôle (6) est réalisée par une zone de diffusion dans le film semi-conducteur, la grille flottante (16) étant formée au-dessus de la zone de canal (8) entre la zone de source (S) et la zone de drain (D), et au-dessus de la grille de contrôle (6).

3. Dispositif selon l'une des revendications 1 ou 2, les zones d'isolement (10, 12, 14) étant réalisées par un oxyde de champ.

4. Dispositif selon l'une des revendications 1 à 3, le film semi-conducteur étant en silicium.

5. Dispositif selon la revendication 4, le film semi-conducteur ayant une épaisseur comprise entre 0,1 µm et 0,3 µm.

6. Dispositif selon l'une des revendications 1 à 5, le point mémoire étant associé à un transistor de sélection.

7. Dispositif à mémoire non-volatile, comportant une pluralité de dispositifs (20, 22, 24, 26) selon l'une des revendications 1 à 5, chaque point mémoire étant associé à un transistor de sélection (28, 30, 32, 34) pour permettre la commande et/ou l'effacement dudit point mémoire.

8. Dispositif de mémorisation comportant une pluralité de dispositifs selon l'une des revendications 1 à 5, un transistor de sélection étant associé à une pluralité de points mémoires pour permettre la commande et/ou l'effacement de ladite pluralité de points mémoire.

9. Procédé de fabrication d'un dispositif à mémoire conforme à l'une des revendications 1 à 7 ou d'un dispositif de mémorisation conforme à la revendication 8, comportant les étapes suivantes :
- formation d'un support par la réalisation d'un film semi-conducteur de type P sur un empilement formé par une couche isolante (4) et un substrat (2),
- formation de zones d'isolement (10, 12, 14) en contact avec la couche isolante (4),
- réalisation d'une zone de canal (8) et d'une zone de grille de contrôle (6), par dopage successif d'ions dans le film semi-conducteur, le dopage de la zone de canal (8) étant de type P, le dopage de la zone de grille de contrôle étant de type P+, et ces zones étant séparées l'une de l'autre par une desdites zones d'isolement (14),
- réalisation d'une grille flottante (16), au-dessus de la zone de canal (8) et de la zone de grille de contrôle (6), et isolée de la zone de canal (8) et de la zone de grille de contrôle (6),
- réalisation d'une zone de drain (D) et d'une zone de source (S) par dopage d'ions, de part et d'autre de la grille flottante (16), le dopage des zones de drain (D) et de source (S) étant de type N+,
- réalisation de connexions reliées respectivement à la zone de drain (D), à la zone de source (S), et à la zone de grille de contrôle (6).

10. Procédé selon la revendication 9, le film semi-conducteur ayant une épaisseur comprise entre 0,1 µm et 0,3 µm.

11. Procédé selon l'une des revendications 9 ou 10, les zones d'isolement (10, 12, 14) étant formées par oxydation thermique.

12. Procédé selon l'une des revendications 9 ou 10, les zones d'isolement (10, 12, 14) étant formées par photolithogravure du film semi-conducteur.

## Claims

1. Electrically erasable, non-volatile memory device, having, in a P-type semiconductor film separated from an insulating layer (4) of a substrate (2), a memory cell of the floating gate type (16), defined by a source zone (S), a drain zone (D), a channel zone (8) and a control gate zone (6), the latter being separated from the channel zone (8) by an insulation zone (14), these five zones being implemented in said semiconductor film, said memory cell being laterally insulated by one or more insulation zones (10,12), the doping of the channel zone (8) being of the P type, the doping of the source (S) and drain zones (D) being of the N+ type, **characterized in that** said insulating zones (10,12,14) are in contact with said insulating layer (4) and the doping of the control gate zone (6) being of the P+ type.

2. Device according to claim 1, wherein said memory cell is a transistor whose control gate (6) is implemented by a diffusion zone in the semiconductor film, the floating gate (16) being formed above a channel zone (8) between the source zone (S) and the drain zone (D) and above the control gate (6).

3. Device according to one of the claims 1 or 2, the insulation zones (10,12,14) being implemented by a field oxide.

4. Device according to one of the claims 1 to 3, the semiconductor film being of silicon.

5. Device according to claim 4, the semiconductor film having a thickness between 0.1 µm and 0.3 µm.

6. Device according to one of the claims 1 to 5, the memory cell being associated with a selection transistor.

7. Non-volatile memory device incorporating a plurality of devices (20, 22, 24, 26) according to one of the claims 1 to 5, each memory cell being associated with a selection transistor (28, 30, 32, 34) to permit the control and/or erasing of said memory cell.

8. Storage device incorporating a plurality devices according to one of claims 1 to 5, a selection transistor being associated with a plurality of memory cells to permit the control and/or erasing of said plurality of memory cells.

9. Process for manufacturing a memory device according to one of claims 1 to 7 or a storage device according to claim 8 comprising the following steps:
- formation of a support by producing a P-type semiconductor film on a stack formed by an electrically insulating layer (4) and a substrate (2),
- formation of insulation zones (10, 12, 14) in contact with the insulating layer (4),
- producing a channel zone (8) and a control gate zone (6), by successive doping by ions in the semiconductor film, the doping of the channel zone (8) being of the P type, the doping of the control gate zone (6) being of the P+ type, and these zones being insulated by one of said insulation zones (14),
- producing a floating gate (16), above the channel zone (8) and the control gate zone (6), and insulated from the channel zone (8) and the control gate zone (6),
- producing a drain zone (D) and a source zone (S) by doping ions in the semiconductor film on either side of the floating gate (16), the doping of said drain and source zones being of the N+ type;
- producing connections connected respectively to the drain zone (D), the source zone (S) and the control gate zone (6).

10. Process according to claim 9, said semiconductor film having a thickness between 0.1 µm and 0.3 µm.

11. Process according to one of the claims 9 and 10, the insulation zones (10, 12, 14) being formed by thermal oxidation.

12. Process according to one of the claims 9 and 10, the insulation zones (10, 12, 14) being formed by photoengraving of the semiconductor film.

## Patentansprüche

1. Vorrichtung mit einem nicht-volatilen, elektrisch löschbaren Speicher, die in einem Halbleiterfilm vom Typ P, der mittels einer isolierenden Schicht (4) von einem Substrat (2) getrennt ist, einen Speicherpunkt vom Typ mit schwebendem Gate (16) umfasst, definiert durch eine Source-Zone (S), eine Drain-Zone (D), eine Kanal-Zone (8) sowie eine Steuergate-Zone (6), wobei Letztere mittels einer Isolierzone (14) von der Kanal-Zone (8) getrennt ist, wobei diese fünf Zonen in dem Halbleiterfilm realisiert sind, wobei dieser Speicherpunkt lateral durch eine oder mehrere Isolierzone(n) (10, 12) isoliert ist, wobei die Dotierung der Kanal-Zone (8) vom Typ P ist, wobei die Dotierung der Source-Zone (S) und der Drain-Zone (D) vom Typ N+ ist,
**dadurch gekennzeichnet, dass**
die Isolierzonen (10, 12, 14) in Kontakt mit der Isolierschicht (4) sind, und dass die Dotierung der Steuergate-Zone (6) vom Typ P+ ist.

2. Vorrichtung nach Anspruch 1, wobei der Speicherpunkt ein Transistor ist, dessen Steuergate (6) mittels einer Diffusionszone in dem Halbleiterfilm realisiert ist, wobei das schwebende Gate (16) über der Kanal-Zone (8) zwischen der Source-Zone (S) und der Drain-Zone (D) sowie über dem Steuergate (6) gebildet ist.

3. Vorrichtung nach einem der Ansprüche 1 oder 2, wobei die Isolierzonen (10, 12, 14) mittels eines Feldoxids realisiert sind.

4. Vorrichtung nach einem der Ansprüche 1 bis 3, wobei der Halbleiterfilm aus Silizium ist.

5. Vorrichtung nach Anspruch 4, wobei der Halbleiterfilm eine Dicke aufweist, die zwischen 0,1 µm und 0,3 µm enthalten ist.

6. Vorrichtung nach einer der Ansprüche 1 bis 5, wobei der Speicherpunkt einem Auslesetransistor zugeordnet ist.

7. Vorrichtung mit einem nicht-volatilen Speicher, umfassend eine Mehrzahl von Vorrichtungen (20, 22, 24, 26) nach einem der Ansprüche 1 bis 5, wobei jeder Speicherpunkt einem Auslesetransistor (28, 30, 32, 34) zugeordnet ist, um die Steuerung und/oder die Löschung des Speicherpunkts zu ermöglichen.

8. Speichervorrichtung, umfassend eine Mehrzahl von Vorrichtungen nach einem der Ansprüche 1 bis 5, wobei ein Auslesetransistor einer Mehrzahl von Speicherpunkten zugeordnet ist, um die Steuerung und/oder die Löschung der Mehrzahl von Speicherpunkten zu ermöglichen.

9. Verfahren zur Herstellung einer Vorrichtung mit einem Speicher gemäß einem der Ansprüche 1 bis 7 oder einer Speichervorrichtung gemäß Anspruch 8, umfassend die folgenden Schritte:
- Bilden eines Trägers durch Realisierung eines Halbleiterfilms vom Typ P auf einem Stapel, der durch eine Isolierschicht (4) und ein Substrat (2) gebildet ist,
- Bilden von Isolierzonen (10, 12, 14) in Kontakt mit der Isolierschicht (4),
- Realisieren einer Kanal-Zone (8) und einer Steuergate-Zone (6) durch sukzessives Dotieren von Ionen in dem Halbleiterfilm, wobei die Dotierung der Kanal-Zone (8) vom Typ P ist, wobei die Dotierung der Steuergate-Zone vom Typ P+ ist, und wobei diese Zonen mittels einer der Isolierzonen (14) voneinander getrennt sind,
- Realisieren eines schwebenden Gates (16) über der Kanal-Zone (8) und der Steuergate-Zone (6), das von der Kanal-Zone (8) und der Steuergate-Zone (6) isoliert ist,
- Realisieren einer Drain-Zone (D) und einer Source-Zone (S) durch Dotieren von Ionon auf beiden Seiten des schwebenden Gates (16), wobei die Dotierung der Drain-Zone (D) und der Source-Zone (S) vom Typ N+ ist,
- Realisierten von Anschlüsse, die mit der Drain-Zone (D), der Source-Zone (S) bzw. der Steuergate-Zone (6) verbunden sind.

10. Verfahren nach Anspruch 9, wobei der Halbleiterfilm eine Dicke aufweist, die zwischen 0,1 µm und 0,3 µm enthalten ist.

11. Verfahren nach einem der Ansprüche 9 oder 10, wobei die Isolierzonen (10, 12, 14) durch thermische Oxidation gebildet werden.

12. Vorfahren nach einem der Ansprüche 9 oder 10, wobei die Isolierzonen (10, 12, 14) durch Photolithogravieren des Halbleiterfilms gebildet werden.
